# EUROPÄISCHE PATENTSCHRIFT

(11) **EP 1 206 017 B1**
(45) Veröffentlichungstag und Bekanntmachung des Hinweises auf die Patenterteilung: **30.07.2008**
(21) Anmeldenummer: 01126316.7
(22) Anmeldetag: 06.11.2001
(51) Int. Cl.: H01S 3/30, H04B 10/17

(54) **Raman-Verstärker mit mehreren Pumpquellen**
Multi-source pumped Raman amplifier
Amplificateur Raman à plusieurs sources de pompage

(30) Priorität: 14.11.2000 DE 10056328
(43) Veröffentlichungstag der Anmeldung: 15.05.2002
(73) Patentinhaber: Nokia Siemens Networks GmbH & Co. KG, 81541 München (DE)
(72) Erfinder: Krummrich, Peter, Dr., 81379 München (DE)

(56) Entgegenhaltungen:
- EP-A- 1 018 666
- WO-A-00/49721
- US-A- 5 268 786
- US-A- 6 031 660
- EMORI Y ET AL: "100 nm bandwidth flat-gain Raman amplifiers pumped and gain-equalised by 12-wavelength-channel WDM laser diode unit" ELECTRONICS LETTERS, IEE STEVENAGE, GB, Bd. 35, Nr. 16, 5. August 1999 (1999-08-05), Seiten 1355-1356, XP006012489 ISSN: 0013-5194

## Beschreibung

Die Erfindung betrifft einen Raman-Verstärker mit mehreren Pumpquellen nach dem Oberbegriff des Anspruchs 1

Aus "System Margin Enhancement with Raman Gain in Multi-Span WDM-Transmission", Srivastava et al., Technical Digest OFC'99 Friday, February 26,1999 ist es bekannt, verteilte Raman-Verstärker zur Verbesserung des Signal-Rausch-Abstandes einzusetzen. Bei einem Raman-Verstärker wird vorzugsweise entgegen der Übertragungsrichtung mindestens ein Pumpsignal eingespeist, das aufgrund des Raman-Effektes das übertragene Datensignal verstärkt. Da meist breitbandige Wellenlängen-Muliplexsignale übertragen werden, sind mehrere Pumpquellen vorgesehen, um einen möglichst flachen oder einen anderen gewünschten wellenlängenabhängigen Verlauf der Raman-Verstärkung zu erhalten. Bei bisherigen eingesetzten Raman-Pumpquellen werden die Pumpleistungen der einzelnen Laserdioden durch konstante Injektionsströme konstant gehalten. Eine derartige Steuerung der Laser-Ausgangsleistungen kann jedoch aufgrund von Temperaturänderungen zu Schwankungen führen. Weiterhin kann eine Alterung der Laserdioden zu einer Abnahme der Pumpleistung führen. Bisherige Regelungen mit Hilfe von Monitordioden an der hinteren Stirnfläche der Laser reichen nicht aus, um die Pumpleistung ausreichend konstant zu halten.

Bei heute eingesetzten WDM-Übertragungssystemen darf sich ferner der Pegel einzelner Teilsignale des WDM-Signals auch dann nicht ändern, wenn einzelne Kanäle zu- oder abgeschaltet werden. Ferner ist es erforderlich, die Verstärker an die Eigenschaften von Streckenabschnitten, insbesondere an den Fasertyp, anzupassen. Weiterhin soll es möglich sein, Übertragungsbänder zu- und abzuschalten.

Weitere Probleme treten auf, wenn eine wechselnde Anzahl von Übertragungsbändern genutzt werden soll. Aufgrund des Raman-Effektes beeinflussen sich die Übertragungsbänder gegenseitig.

In der Patentanmeldung EP 1018666 wird ein Raman-Verstärker mit mehreren Laser-Pumpquellen beschrieben, denen jeweils ein Faser-Grating zur Frequenzstabilisierung nachgeschaltet ist. Die frequenzstabilisierten Pumpsignale werden zusammengefasst und entgegen der Übertragungsrichtung in eine als Raman-Verstärker wirkende Übertragungsfaser eingespeist. Durch die Verwendung mehrerer Pumpquellen wird ein linearer bzw. gewünschter Verstärkungsverlauf als Funktion der Wellenlänge erzielt.

Alle Pumpquellen werden gemeinsam in Abhängigkeit vom Empfangssignal geregelt. Da die Laser aber unterschiedlich schnell altern und die Verstärkung zudem von der Polarisation abhängig ist, wird kein optimaler Verstärkungsverlauf erzielt.

Bei einem in dem Patent US 5,268,786 beschriebenen Faserverstärker werden zwei parallel geschaltete Pumpquellen mit gleicher Wellenlänge verwendet, deren Ausgangssignale durch separate Regelkreise intern geregelt und von dem Ausgangssignal des Verstärkers derart gesteuert werden, daß die Ausgangsleistung konstant bleibt. Die Regelzeitkonstanten sind für beide Pumpquellen unterschiedlich, um günstiger auf Veränderungen eines Einganssignal reagieren zu können. Eine Linearisierung des Verstärkungsverlaufs wird hierdurch nicht erreicht.

Aufgabe der Erfindung ist es, bei einem Raman-Verstärker den gewünschten Verstärkungsverlauf konstant zu halten sowie eine Abhängigkeit der Verstärkung von der Polarisation der Signale zu vermeiden. Eine weitere Teilaufgaben besteht darin, den Raman-Verstärker für WDM-Signale (Wellenlängen-Multiplex-Signale) mit unterschiedlichen Kanalzahlen auszulegen und eine Anpassung an unterschiedlichen Übertragungsstrecken und Betriebsbedingungen zu ermöglichen.

Die Hauptaufgabe wird durch einen Raman-Verstärker gemäß Patentanspruch 1 gelöst.

In den Unteransprüchen sind vorteilhafte Weiterbildungen des Raman-Verstärkers für angegeben.

Vorteilhaft bei dem erfindungsgemäßen Raman-Verstärker ist die Konstanz der Pumpleistungen und der Pumpwellenlängen. Diese wird durch individuelle Filterung und Regelung der einzelnen Pumpquellen erreicht. Polarisations-Mischer (Polarisatoren) sorgen durch eine Verwürflung der Polarisation, um eine von der Polarisation des WDM-Signals unabhängige Verstärkung zu erreichen.

Da der Raman-Verstärker in WDM-Systemen eingesetzt wird, soll das Zu- oder Abschalten eines oder mehrerer Übertragungskanäle keinen Einfluß auf die übrigen Kanäle haben. Deshalb wird der Raman-Verstärker im linearen Bereich betrieben.

Vorteilhaft ist eine Steuerung, die zur Anpassung an unterschiedliche Übertragungsabschnitte und Übertragungsverhältnisse die Pumplaser optimal ansteuert.

Ausführungsbeispiele der Erfindung werden anhand von Figuren näher erläutert.

Es zeigen:
- Figur 1: einen Raman-Verstärker mit geregelten Pumpquellen und
- Figur 2: eine entsprechende Anordnung mit ergänzter Steuerung.

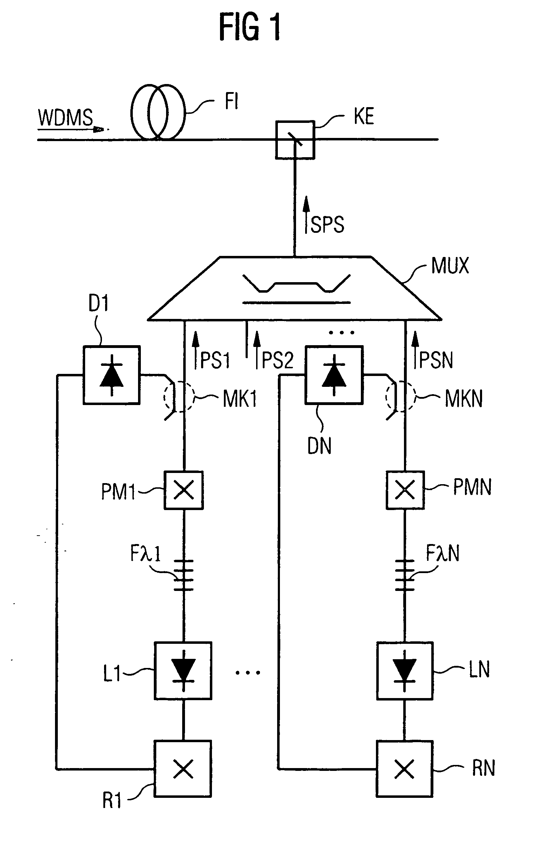

**Figur 1** zeigt ein Prinzipschaltbild eines erfindungsgemäßen Raman-Verstärkers mit mehreren Pumpquellen, die ein Summen-Pumpsignal SPS erzeugen, das über eine Koppeleinrichtung KE (Bandweiche) in eine Übertragungsfaser FI entgegen der Übertragungsrichtung eines Wellenlängenmultiplex-Signals WDMS eingespeist wird. Das Summen-Pumpsignal SPS wird durch Multiplexen mehrerer Einzel-Pumpsignale PS1 - PSN in einem optischen Multiplexer MUX gewonnen. Zur Erzeugung dieser Pumpsignale sind Pumplaser L1 - LN vorgesehen, die jeweils ein Pumpsignal erzeugen. Die Frequenzen der Pumplaser werden durch optische Filter (Fasergitter) Fλ1 - FλN stabilisiert, die jeweils einen geringen Teil der Signale reflektieren. Wenn die Pumplaser bereits die gewünschten Frequenzen und diese eine ausreichende Stabilität (Temperaturschwankungen, Alterung usw.) aufweisen, können die optischen Filter entfallen.

Um von der Polarisation des übertragenen Wellenlängen-Multiplexsignals WDMS unabhängig zu sein, sollte jedes Pumpsignal einen Polarisations-Mischer PM1 - PMN durchlaufen. Dieser kann als aktives Element ausgeführt sein; eine passive Ausführung ist jedoch vorzuziehen, bei der das Pumpsignal in verschieden polarisierte Komponenten zerlegt wird, die unterschiedlich verzögert und wieder zusammengeführt werden. Die Leistungen (Amplituden) der so gewonnenen Pumpsignal PS1 - PSN werden gemessen, indem jeweils ein geringer Anteil (z. B.

2%) der Pumpsignale über einen Meßkoppler MK1 - MKN ausgekoppelt und einer Monitordiode D1 - DN zugeführt wird. Die so gewonnenen Meßsignale MS1 - MSN steuern über jeweils einen Regler R1 - RN den zugehörigen Pumplaser L1 - LN, um die Leistungen der Pumpsignale konstant zu halten.

Die Leistungen und Frequenzabstände der Pumplaser sind so gewählt, daß im relevanten Wellenlängenbereich ein möglichst flacher oder ein gewünschter Verlauf der Raman-Verstärkung erzielt wird. Die Einstellung der Pumpleistungen kann aufgrund von Messungen der Signalleistungen oder anhand von Tabellen erfolgen, die bereits aufgrund von Referenzmessungen erstellt oder errechnet wurden.

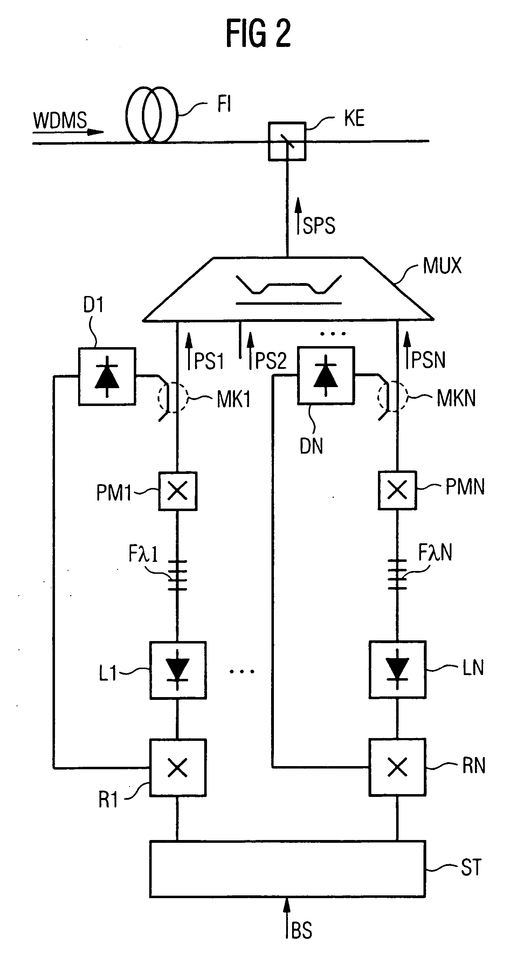

In **Figur 2** ist die vorstehend beschriebene Anordnung um eine Steuerung ST ergänzt. Über diese Steuerung kann die Leistung der einzelnen Pumpsignale durch Änderung der Führungsgrößen der Regler variiert werden. Die für ein flaches Gewinnspektrum (bzw. Pegelverlauf) erforderlichen Pumpleistungen hängen vom Typ der Übertragungsfaser ab. Das Einstellen eines optimalen Gewinnspektrums kann bei Inbetriebnahme daher durch Messung des Gewinnspektrums (bzw. der Pegel) und Einstellen der Ausgangsleistungen der Pumplaser erfolgen. Alternativ kann bei Inbetriebnahme einer Übertragungsstrecke der Steuerung der Fasertyp und gegebenenfalls weitere Systemdaten, beispielsweise die erforderliche Raman-Verstärkung, mitgeteilt werden. Mit Hilfe einer abgespeicherten Tabelle werden die erforderlichen Ausgangsleistungen der Pumplaser durch Änderung der Führungsgrößen eingestellt. Diese Daten werden beispielsweise für unterschiedliche Fasertypen im Labor ermittelt und anschließend in einer Tabelle der Steuerung gespeichert oder dieser extern zugeführt. Beide Methoden können auch kombiniert werden, indem nach einer Einstellung gemäß Tabelle eine Optimierung durch Messungen erfolgt.

Bei der Inbetriebnahme einer Stecke werden alle für ein flaches Gewinnspektrum erforderlichen Pumplaser eingeschaltet.

Hierbei kann auch ein noch nicht genutztes Übertragungsband berücksichtigt werden.

Wird ein Übertragungsband zugeschaltet und ist diese Möglichkeit bei der Einstellung der Pumplaser noch nicht berücksichtigt worden, indem nur ein Teil der Pumplaser für ein Übertragungsband aktiviert war, dann müssen die Leistungen der Pumpsignale neu eingestellt werden. Im Ausführungsbeispiel nach Figur 1 kann dies nur durch individuelle Neueinstellung der Pumpleistungen erfolgen (eine Einstellmöglichkeit für die jeweilige Führungsgröße ist nicht dargestellt). Entsprechend Figur 2 kann diese Einstellung durch ein externes Belegungssignal BS veranlaßt werden, wobei die Einstellungen anhand der in der Steuerung gespeicherten Tabelle erfolgen. Aufgrund des linearen Betriebs des Raman-Verstärkers kann ein Ab- oder Zuschalten einzelner Kanäle ohne Änderung der Pumpleistungen erfolgen.

Nicht berücksichtigt wurde die durch gegenseitige Beeinflussung von mehreren Übertragungsbändern verursachte Verkippung der Pegelverläufe bzw. des Gewinnspektrums. Auch diese kann durch die Steuerung mitberücksichtigt werden.

Bezugszeichenliste
- WDMS: Wellenlängen-Multiplexsignal
- FI: Übertragungsfaser
- Fλ1..FλN: optisches Filter
- PM1..PMN: Polarisationsmischer
- MK1..MKN: Meßkoppler
- D1..DN: Monitordiode
- PS1..PSN: Pumpsignal (Einzel-)
- R1..RN: Regler
- ST: Steuerung
- KE: Koppeleinrichtung
- MUX: Multiplexer
- BS: Belegungssignal
- MS1-MSN: Meßsignal
- SPS: Summen-Pumpsignal

## Patentansprüche

1. Raman-Verstärker mit mehreren Pumplasern (L1- LN), die Pumpsignale (PS1 - PSN) unterschiedlicher Frequenz erzeugen, welche über einen Wellenlängen-Multiplexer (MUX) zusammengefaßt und in eine Übertragungsfaser (FI) eingespeist werden,
**dadurch gekennzeichnet,**
**daß** jeder Pumplaser (L1 -LN) in einem Regelkreis (R1, L1, Fλ1, MK1, D1, ..., RN, LN, FλN, MKN, DN) angeordnet ist, der die Leistung des zugehörigen Pumpsignals (PS1 - PSN) konstant hält, und
**daß** jeweils ein Polarisations-Mischer (PM1 - PMN) in Reihe mit jedem der Pumplaser (L1 - LN) geschaltet ist.

2. Raman-Verstärker nach Anspruch 1,
**dadurch gekennzeichnet,**
**daß** jeweils in Reihe mit jedem der Pumplaser (L1 - LN) ein optisches Filter (Fλ1 - FλN) zur Frequenzstabilisierung angeordnet ist.

3. Raman-Verstärker nach Anspruch 1 oder Anspruch 2,
**dadurch gekennzeichnet,**
**daß** zur Leistungsregelung der Pumpsignale (PS1 -PSN) in jedem Regelkreis (R1, L1, Fλ1, MK1, D1, ..., RN, LN, FλN, MKN, DN) ein Meßkoppler (MK1 - MKN) und eine Monitordiode (D1 - DN) angeordnet sind, deren Meßsignal (MS1 - MSN) über einen Regler (R1 - RN) den Injektionsstrom des Pumplasers (L1 - LN) und damit die Leistung des Pumpsignals (PS1 - PSN) steuert.

4. Raman-Verstärker nach einem der vorhergehenden Ansprüche,
**dadurch gekennzeichnet,**
**daß** er im linearen Bereich arbeitet.

5. Raman-Verstärker nach einem der vorhergehenden Ansprüche,
**dadurch gekennzeichnet,**
**daß** die Leistungen der Pumpsignale (PS1 - PSN) so eingestellt sind, daß er im relevanten Wellenlängenbereich einen flachen oder gewünschten Verstärkungsverlauf aufweist.

6. Raman-Verstärker nach einer der vorhergehenden Ansprüche,
**dadurch gekennzeichnet,**
**daß** eine Steuerung (ST) vorgesehen ist, die Führungsgrößen für alle Regler (R1 - RN) liefert und die aufgrund gespeicherter oder extern zugeführter Daten oder Signale (BS) die Leistungen der Pumpsignale (PS1 - PSN) für einen optimalen Verstärkungsverlauf einstellt.

7. Raman-Verstärker nach einer der vorhergehenden Ansprüche,
**dadurch gekennzeichnet,**
**daß** die Steuerung (ST) einen Eingang für ein Belegungssignal (BS) aufweist, das die aktiven Übertragungsbänder angibt und anhand von gespeicherten Tabellen einen Teil der Pumplaser (L1 - LN) aktiviert oder abschaltet und die Leistungen der Pumpsignale (PS1 - PSN) für einen optimalen Verstärkungsverlauf einstellt.

8. Raman-Verstärker nach einer der vorhergehenden Ansprüche,
**dadurch gekennzeichnet,**
**daß** die Steuerung (ST) eine Verkippung der Signalpegel bei Ausfall oder Abschalten und bei Zuschalten eines Übertragungsbandes ausregelt.

## Claims

1. Raman amplifier having a plurality of pump lasers (L1-LN) which generate pump signals (PS1-PSN) of different frequency which are combined using a wavelength-division multiplexer (MUX) and are fed into a transmission fibre (FI),
**characterized**
**in that** each pump laser (L1-LN) is arranged in a control loop (R1, L1, Fλ1, MK1, D1, ..., RN, LN, FλN, MKN, DN) which keeps the power of the associated pump signal (PS1-PSN) constant, and
**in that** a respective polarization mixer (PM1-PMN) is connected in series with each of the pump lasers (L1-LN).

2. Raman amplifier according to Claim 1,
**characterized**
**in that** an optical filter (Fλ1-FλN) for frequency stabilization is respectively arranged in series with each of the pump lasers (L1-LN).

3. Raman amplifier according to Claim 1 or Claim 2,
**characterized**
**in that** for the purpose of regulating the power of the pump signals (PS1-PSN) each control loop (R1, L1, Fλ1, MK1, D1, ..., RN, LN, FλN, MKN, DN) contains a measurement coupler (MK1-MKN) and a monitor diode (D1-DN) whose measurement signal (MS1-MSN) via a regulator (R1-RN) controls the injection current of the pump laser (L1-LN) and hence the power of the pump signal (PS1-PSN).

4. Raman amplifier according to one of the preceding claims,
**characterized**
**in that** it operates in the linear range.

5. Raman amplifier according to one of the preceding claims,
**characterized**
**in that** the powers of the pump signals (PS1-PSN) are set such that it has a flat or desired gain profile in the relevant wavelength range.

6. Raman amplifier according to one of the preceding claims,
**characterized**
**in that** a controller (ST) is provided which delivers reference variables for all regulators (R1-RN) and which takes stored or externally supplied data or signals (BS) as a basis for setting the powers of the pump signals (PS1-PSN) for an optimum gain profile.

7. Raman amplifier according to one of the preceding claims,
**characterized**
**in that** the controller (ST) has an input for a busy signal (BS) which indicates the active transmission bands and uses stored tables to activate or disconnect some of the pump lasers (L1-LN) and to set the powers of the pump signals (PS1-PSN) for an optimum gain profile.

8. Raman amplifier according to one of the preceding claims,
**characterized**
**in that** the controller (ST) corrects changes in the signal levels in the event of failure or disconnection and in the event of connection of a transmission band.

## Revendications

1. Amplificateur Raman comprenant plusieurs lasers de pompage (L1-LN), qui génèrent des signaux de pompage (PS1-PSN) de fréquence différente, lesquels sont regroupés au moyen d'un multiplexeur à répartition en longueur d'onde (MUX) et sont injectés dans une fibre de transmission (FI),
**caractérisé en ce que**
chaque laser de pompage (L1-LN) est disposé dans un circuit régulateur (R1, L1, Fλ1, MK1, D1,..., RN, LN, FλN, MKN, DN) qui maintient constante la puissance du signal de pompage (PS1-PSN) spécifique et
**en ce que** à chaque fois un mélangeur de polarisation (PM1-PMN) est branché en série avec chacun des lasers de pompage (L1-LN).

2. Amplificateur Raman selon la revendication 1,
**caractérisé en ce que**
un filtre (Fλ1-FλN) optique pour la stabilisation de la fréquence est disposé à chaque fois en série avec chacun des lasers de pompage (L1-LN).

3. Amplificateur Raman selon la revendication 1 ou la revendication 2,
**caractérisé en ce que**,
pour le réglage de puissance des signaux de pompage (PS1-PSN), un coupleur de mesure (MK1-MKN) et une diode de moniteur D1-DN sont disposés dans chaque circuit régulateur (R1, L1, Fλ1, MK1, D1,..., RN, LN, FλN, MKN, DN), dont le signal de mesure (MS1-MSN) commande au moyen d'un régulateur (R1-RN) le courant d'injection du laser de pompage (L1-LN) et donc la puissance du signal de pompage (PS1-PSN).

4. Amplificateur Raman selon l'une quelconque des revendications précédentes,
**caractérisé en ce que**
il travaille dans la plage linéaire.

5. Amplificateur Raman selon l'une quelconque des revendications précédentes,
**caractérisé en ce que**,
les puissances des signaux de pompage (PS1-PSN) sont réglées de telle sorte qu'il présente dans la plage de longueurs d'onde pertinente une courbe d'amplification plate ou souhaitée.

6. Amplificateur Raman selon l'une quelconque des revendications précédentes,
**caractérisé en ce que**
il est prévu une commande (ST) qui fournit des grandeurs de guidage pour tous les régulateurs (R1-RN) et qui règle les puissances de signaux de pompage (PS1-PSN) pour une courbe d'amplification optimale sur la base de données ou signaux (BS) stockés ou amenés de façon externe.

7. Amplificateur Raman selon l'une quelconque des revendications précédentes,
**caractérisé en ce que**
la commande (ST) présente une entrée pour un signal d'occupation (BS), qui indique les bandes de transmission actives et active ou déconnecte une partie des lasers de pompage (L1-LN) à l'aide de tableaux stockés et règle les puissances des signaux de pompage (PS1-PSN) pour une courbe d'amplification optimale.

8. Amplificateur Raman selon l'une quelconque des revendications précédentes,
**caractérisé en ce que**
la commande (ST) règle un basculement des niveaux de signal en cas de défaillance ou de déconnexion et en cas de mise en circuit d'une bande de transmission.
